# EUROPEAN PATENT SPECIFICATION

(11) **EP 3 538 883 B1**
(45) Date of publication and mention of the grant of the patent: **01.05.2024**
(21) Application number: 17719015.4
(22) Date of filing: 14.03.2017
(51) Int. Cl.: G01N 27/414, H01L 29/786

(54) **SENSITIVE FIELD EFFECT DEVICE**
SENSITIVE FELDEFFEKTVORRICHTUNG
DISPOSITIF SENSIBLE A EFFET DE CHAMP

(30) Priority: 14.11.2016 PT 2016082412
(43) Date of publication of application: 18.09.2019
(73) Proprietor: Alma Mater Studiorum - Università di Bologna, 40126 Bologna (BO) (IT); Universidade Nova de Lisboa, 1099-085 Lisboa (PT)
(72) Inventor: FERRÃO DE PAIVA MARTINS, Rodrigo, 2820-292 Charneca da Caparica (PT); BARQUINHA, Pedro Miguel Cândido, 1885-100 Moscavide (PT); CORREIA FORTUNATO, Elvira Maria, 2820-292 Charneca da Caparica (PT); CRAMER, Tobias, 40067 Pianoro (BO) (IT); FRABONI, Beatrice, 40136 Bologna (IT)
(74) Representative: Tiburzi, Andrea
(86) International application number: PCT/IT2017/000050
(87) International publication number: WO 2018/087787

(56) References cited:
- CN-A- 105 870 173
- US-A1- 2015 330 941
- TOBIAS CRAMER ET AL: "Radiation-Tolerant Flexible Large-Area Electronics Based on Oxide Semiconductors", ADVANCED ELECTRONIC MATERIALS, vol. 2, no. 7, 19 May 2016 (2016-05-19), page 1500489, XP055387696, ISSN: 2199-160X, DOI: 10.1002/aelm.201500489
- ZHAO CHUMIN ET AL: "Amorphous In-Ga-Zn-O thin-film transistor active pixel sensor x-ray imager for digital breast t", MEDICAL PHYSICS, AIP, MELVILLE, NY, US, vol. 41, no. 9, 12 August 2014 (2014-08-12), XP012188657, ISSN: 0094-2405, DOI: 10.1118/1.4892382 [retrieved on 1901-01-01]
- LUJAN R A ET AL: "Flexible X-Ray Detector Array Fabricated With Oxide Thin-Film Transistors", IEEE ELECTRON DEVICE LETTERS, IEEE SERVICE CENTER, NEW YORK, NY, US, vol. 33, no. 5, 1 May 2012 (2012-05-01), pages 688-690, XP011441964, ISSN: 0741-3106, DOI: 10.1109/LED.2012.2188825
- H TSAI ET AL: "Comprehensive Nuclear Material Surveillance with a Radiation Detector-Equipped ARG-US RFID System INTRODUCTION", JW MARRIOTT DESERT SPRINGS, 18 July 2013 (2013-07-18), XP055387948,
- CRAMER TOBIAS ET AL: "Passive radiofrequency x-ray dosimeter tag based on flexible radiation-sensitive oxide field-effect transistor", SCIENCE ADVANCES, vol. 4, no. 6, 29 June 2018 (2018-06-29), XP055929707, DOI: 10.1126/sciadv.aat1825

## Description

The present invention relates to a sensitive field effect device.

More specifically, the invention concerns a field effect transistor, designed to feature a low leakage current as well as a high bandwidth, so as to be highly sensitive, if compared with analogous sensors according to the prior art. The field effect transistor is also particularly indicated for detecting circuits and designed to detect several kind of physical quantities, such as temperature, mechanical stresses, light, chemicals, ionizing radiation, such as X-rays and the like, and also suitable to be arranged in flexible substrates arrays or matrix.

In the following, the description will be directed to the field effect devices adapted to sense several kind of physical phenomena, better discussed below, but the sole embodiment directed to the detection of ionization radiation falls within the scope of the present invention.

As it is well known, currently high sensitivity sensors are requested by industry and scientific search, in order to detect different physical phenomena.

By way of example, it is increasing the diffusion of RFIDs receivers, to be connected to specific chips probes, generally made of transistors, usually realized in CMOS technology.

It is also known that low-cost RFID chips exhibit an auxiliary terminal for sensor connections. A RFID chip probes impedance of the connected sensor at high bandwidth (of the order of 100 kHz). An impedance Z greater of 20 MΩ results in the state 0, instead a value of said impedance Z below 2 MΩ results in the state 1.

A technical problem currently felt in the field is that of creating sensors that (i) operate at the high bandwidth of RFID, while consuming little power, (ii) show an order of magnitude variation in impedance response in a given range triggered by the sensing event, (iii) maintain the impedance variation also after the occurrence of the sensing event and (iv) are compliant to low cost-mass production technology.

Nowadays, RFID chips are based on CMOS technology, which however features some limits to accomplish the above objectives, due to the current leakage phenomena, which increase considerably the power consumption of the single field effect transistor.

In order to deepen the necessity of devices capable of overcoming the technical drawbacks of the available prior art devices, more remarks on specific technical problems of radiation detection and dosimetry are outlined below.

It is in fact well known that currently radiation detection and dosimetry is of relevance in medical imaging and radiotherapy, protection of personnel working in potentially contaminated areas such as nuclear reactors, nuclear waste deposits, luggage security screening and dosimetry in radiation harsh environments, such as space.

In many cases, a wearable detector is needed, which combines low-voltage and low-power operation with high sensitivity, low-weight and flexible mechanical properties.

Existing dosimeters for ionizing radiation can be distinguished in two different main classes, both showing specific drawbacks.

A first type of dosimeters is based on thermoluminescent phosphate glasses or gafchromic film and can actually achieve a high sensitivity. However, as a drawback, these dosimeters do not allow real-time detection of the radiation, but require readout in a dedicated instrument after exposure by optical techniques.

A second type of dosimeters employs silicon complementary metal oxide semiconductor electronics and provides direct electronic readout, thus providing real-time data about radiation exposure. Drawbacks of this technical approach are reduced sensitivities due to the absorption of only a fraction of exposed ionizing particles, mechanical rigidity of the sensors and the impossibility to process devices on large areas of flexible substrates. In addition, as a further drawback, these devices are not mechanically flexible, and therefore of limited use for wearable dosimeters.

The relevant prior art comprises the scientific paper by Tobias Cramer et al. "Radiation - Tolerant Flexible Large Area Electronics based on Oxide Semiconductors", the scientific paper by Zhao Chumin et al. "Amorphous In-Ga-Zn-O thin-film transistor active pixel sensor x-ray imager for digital...", the patent application US 2015/330941 A1, the scientific paper by Lujan R. et al. "Flexible X-Ray detector Array Fabricated With Oxide Thin-Film Transistors", and the scientific paper by H. Tsai et al. "Comprehensive Nuclear Material Surveillance with a Radiation Detector-Equipped ARG-US RFID System Introduction.

In view of the above, it is an object of the present invention to overcome the drawbacks of the prior art devices, in order to achieve a high sensitivity device for detecting ionization radiations, such as X-rays and the like.

It is also object of the invention providing a flexible device featuring real-time electronic readout of radiation exposure.

It is another object of the invention to provide a device architecture capable of increasing the amount of X-ray photon absorption and then the sensitivity.

It is therefore specific object of the present invention a high sensitive and high bandwidth field effect transistor that allows to detect even small changes of physical phenomena.

It is also specific object of the present invention a flexible ionization sensitive field effect transistor (FISFET) that allows to detect and monitor ionizing radiation (e.g. X-rays, gamma, neutrons alpha, beta rays).

The present invention provides a detecting sensor in accordance with claim 1. Advantageus features are provided in the dependent claims.

There is also described a method for manufacturing a field effect device, which is not part of the present invention and comprises the following steps: (A) depositing said gate electrode on said flexible substrate and carrying out a photolithography and etching process or lift-off on said gate electrode; (B) depositing said dielectric layer and carrying out a photolithography and etching process or lift-off on said dielectric layer; (C) depositing said semiconductor channel and carrying out a photolithography and etching process or lift-off on said semiconductor channel; (D) carrying out a photolithography process on said semiconductor channel and depositing said source electrode and said drain electrode; and (E) patterning said source electrode and said drain electrode by lift-off.

Said step (B) could be carried out by RF-sputtering, performed in parallel from two separate targets containing said insulating material of said insulating layer and said material of said main layer of said dielectric, and/or via solution-based processes containing said material of said insulating layer and said material of said main layer of said dielectric, so as to create the multilayer structure of said dielectric layer, by alternating depositions of an insulating layer only, such as silicon-dioxide (SiO₂) and/or aluminum-oxide (Al₂O₃), and co-depositions of an insulating material, such as silicon-dioxide (SiO₂) and/or aluminum-oxide (Al₂O₃), and said material of said main layer of said dielectric.

The present invention will now be described, for illustrative but not limitative purposes, according to its preferred embodiments, with particular reference to the figures of the enclosed drawings, wherein:
figure 1 shows a perspective scheme of the architecture of a single ionization sensitive field effect device according to the present invention;
figure 2 shows arrays of ionization sensitive field effect device according to figure 1 arranged on a flexible substrate;
figures 3a, 3b and 3c show a simplified model for explaining the ionization damage effect and the related carrier accumulation in the ionization sensitive field effect device of figure 2;
figure 4 shows a plot with transfer characteristics before and after exposure of X-ray radiation;
figures 5a and 5b shows plots of ionization sensitive field effect device threshold voltage Vt before and after exposure for 1 second to X-ray;
figures 6a and 6b shows the dynamics of the ionization sensitive field effect device threshold voltage recovery after X-ray exposure;
figure 7 shows a general electrical connection of the field effect device according to the invention with an RFID transmitter;
figure 8 shows a schematic diagram of the electrical connection of the field effect device according to the invention with an RFID transmitter;
figure 9 shows a characteristic curve of the drain-source impedance Z as a function of the gate-source voltage, together with the RFID logic state function;
figure 10a and 10b show the transfer characteristics of the field effect device according to the invention and its frequency response;
figure 11 shows a circuit diagram of the field effect device according to the present invention adapted to detect ionizing radiations, connected to a RFID transmitter;
figure 12 shows a characteristic curve of the drain - source impedance Z as a function of the gate - source voltage, together with the RFID logic state function referred to figure 11;
figure 13 shows a circuit diagram of the field effect device according to the invention adapted to detect light radiation (which is not part of the present invention);
figure 14 shows the circuit diagram of figure 13 where the field effect device according to the invention is connected to a RFID transmitter (which is not part of the present invention);
figure 15 shows a characteristic curve of the drain - source impedance Z of the field effect device according to the invention is a function of time, together with the RFID logic state (which is not part of the present invention);
figures 16a and 16b show the operation of a circuit diagram of the field effect device according to the invention adapted to detect mechanical stresses (which is not part of the present invention);
figure 17a and 17b show a circuit diagram of the field effect device according to the invention adapted to detect temperature variations (which is not part of the present invention); and
figure 18a and 18b show a circuit diagram of the field effect device according to the invention adapted to detect chemical substances (which is not part of the present invention).

In the various figures, similar parts will be indicated by the same reference numbers.

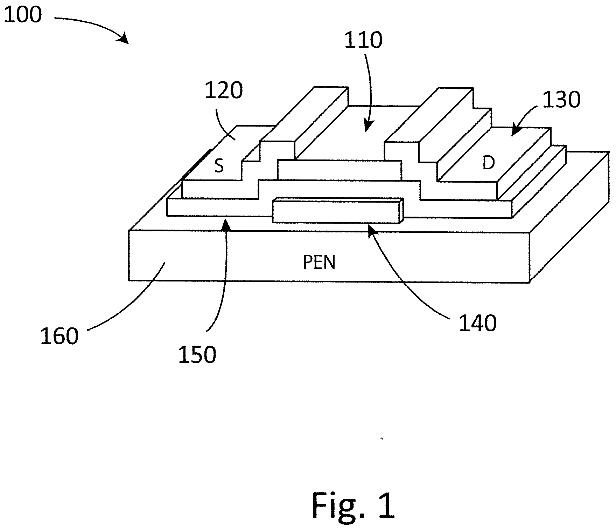

Referring to figure 1, a first embodiment of a field effect device 100 according to the invention is shown, wherein details of the device architecture are also specified, for detecting electromagnetic radiations and particularly ionizing radiations, such as X-rays and the like.

The device 100 mainly comprises source, drain and gate electrodes, indicated with reference numbers 120, 130 and 140 respectively, a semiconductor channel layer 110, arranged on a dielectric layer 150, and a substrate 160.

Said source electrode 120, said drain electrode 130 and said gate electrode 140 are made of a conductive material, such as molybdenum (Mo), copper (Cu), aluminum (Al), gold (Au) or silver (Ag), or even conducting oxides, such as Gallium Zinc Oxide, Indium Zinc Oxide.

Said dielectric layer 150 has a thickness greater than 150 nm, so as to prevent the tunneling effects and the relevant leakage currents. This allows also reducing the overall leakage current effects possibly due to other phenomena.

The semiconductor channel layer 110 is arranged between, and in electric contact with said source electrode 120 and said drain electrode 130. Said semiconductor channel layer 110 is made of a high mobility amorphous oxide. In particular, said semiconductor channel layer 110 can be made of Indium Gallium Zinc Oxide (IGZO), Indium Hafnium Zinc Oxide (IHZO), Zinc Tin Oxide (ZTO) or Gallium Zinc Tin Oxide (GZTO).

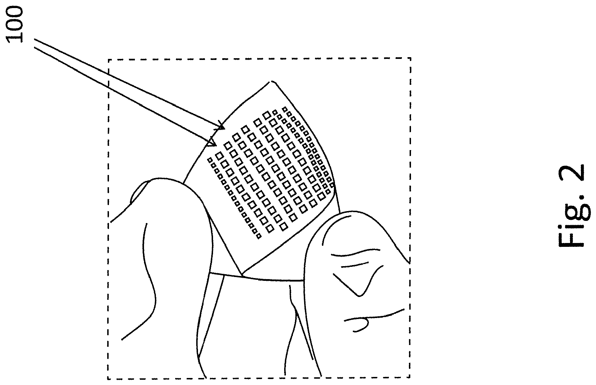

The high mobility amorphous oxides used for said semiconductor channel layer 110 are fabricated by photolithography. They feature high bandwidth, low parasitic capacitance and minimal gate current, as it can be appreciated from figure 2 and are thus compliant to low-voltage operation, particularly with RFID circuits.

Said field effect device 100 comprises also sensor means, so that, upon sensing an event to be detected, the impedance, commonly referred to with the letter Z, of the semiconductor channel layer 110 is varied by over an order of magnitude, thus allowing the connection of a RFID transmitter, as better explained below.

According to the invention, the semiconductor channel layer 110 is exposed to the radiation to be detected.

The sensing means provided in the field effect device 100 according to the present embodiment comprises multilayer dielectric oxide structure dielectric layer 150, comprising a main layer, combined with one or more further layers with lower atomic number atoms.

Said main layer is a high-Z layer, this meaning that the atomic number is higher than 36. In particular, said main layer is made of at least one of the following materials:
- Yttrium Oxide (Y₂O₃);
- Zirconium Oxide (ZrO₂);
- Hafnium Oxide (HfO₂);
- Tantalum Pentoxide (Ta₂O₅);
- Bismuth Oxide (Bi₂O₃).

Said one or more further layers with lower atomic number atoms is an insulating layer that can be for example SiO₂ or Al₂O₃.

The bottom layer of the multicomponent dielectric is said insulating layer with lower atomic number atoms, followed by the main layer. This structure is then repeated two to ten times, followed by a top layer of the said insulating layer with lower atomic number atoms.

The dielectric layer 150 is deposited on said flexible substrates 160 such as Polyethylene Naphthalate, to achieve flexible sensitive field effect device 100. More specifically, in figure 2, arrays patterned on polymeric/plastic substrates are shown, comprising a plurality of ionization sensitive field effect devices 100.

In addition to the above, it is seen that the gate electrode 140 is arranged between said flexible substrates 160 and said dielectric layer 150.

The operation of the device 100, based on the accumulation of ionization charges in the multilayer dielectric oxide structure 150 due to X-ray radiation as described above is as follows.

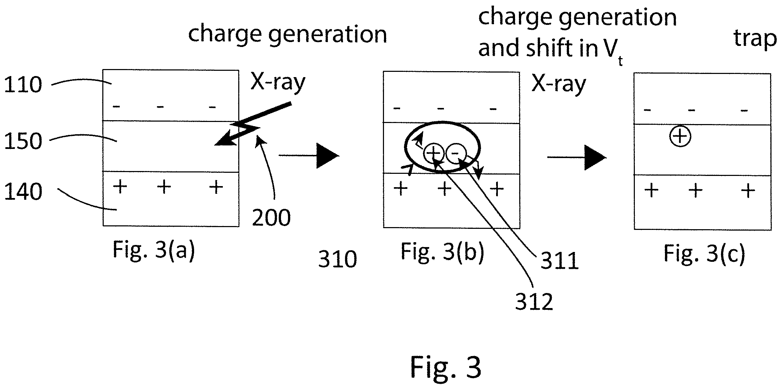

In figures 3a-3c, basic processes how the device operates are schematically depicted.

The formation of ionization charge is initiated by the absorption of a high-energy photon or photoelectron 200 (see figure 3a), giving the generation of an electron hole pair 310 in the dielectric layer 150.

The electrons 311 (see figure 3b) are collected in a fast process, namely faster than respective holes collection process, at the gate electrode 140.

The remaining hole charges 312 move, as said, slowly in a thermally activated hopping process to the interface with the semiconductor channel 110 (see figure 3c).

Thus, as a consequence of X-ray exposure, a larger drain current and a shift in threshold voltage to negative values result.

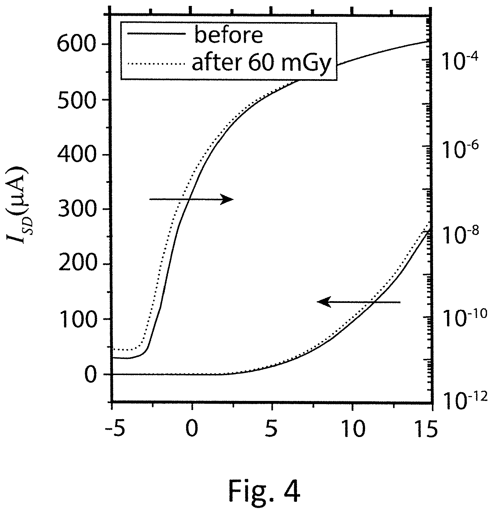

Figure 4 shows as an example ionization sensitive field effect device 100 transfer curves, measured in saturation (drain electrode 130 voltage VD=20 Volts) before and after exposure to a total dose of 60 mGy (in the air; Gy is Gray unit measure) emitted by a molybdenum (Mo)-tube as a X-ray source, operated at a dose rate of 60 mGy/s.

The transfer characteristics show a shift of 0,326 V to more negative gate potentials, after X-ray exposure (reference to figure 3a state). No other transistor parameter, such as sub-threshold slope or mobility is influenced by the exposure.

The shift is a consequence of the positive carriers accumulation at the interfaces between the dielectric layer 150 and the semiconductor channel 110 (see figure 3c). Positive carriers accumulation influences the voltage between said source electrodes 120 and said gate electrode 130 at fixed current flux. By measuring the variation of the gate potentials, it is possible to infer the amount of X-ray dose to which the device 100 has been exposed to.

Sensitivity of the device 100 to ionization depends crucially on the composition and thickness of the high-Z dielectric multilayer 150.

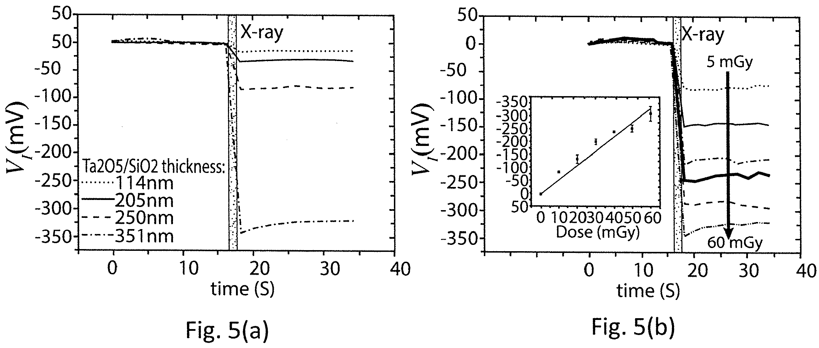

Low X-ray attenuation length (λ < 60 µm) in this layer is achieved due to the high atomic number (e.g. using Tantalum Oxide), whereas an oxide layer (e.g. SiO₂) serves to maintain good isolating and interfacial properties. Increasing the thickness of multilayer dielectric oxide structure 150 allows to further improve the X-ray response, as demonstrated in figure 5a. This figure shows how, by increasing the thickness of the dielectric layer 150 from 114 nm to 381 nm, the threshold shift increases by a factor of 6 as well.

Furthermore the ionization sensitive field effect device 100 according to the invention, allows to perform quantitative dosimetry by monitoring variations in threshold, as it offers a linear dependency between exposure dose and threshold shift for total doses remaining below 100 mGy.

This finding is shown in figure 5b, which shows the variation of threshold voltage caused by exposure to X-ray 200 of varying dose-rates for a period of 1 sec. The inset shows the resulting shift in threshold voltage as a function of dose. The linear fit results in a sensitivity of 5,5 mV/mGy.

The device 100 operates as an integrating dosimeter and maintains the threshold voltage after the X-ray exposure event.

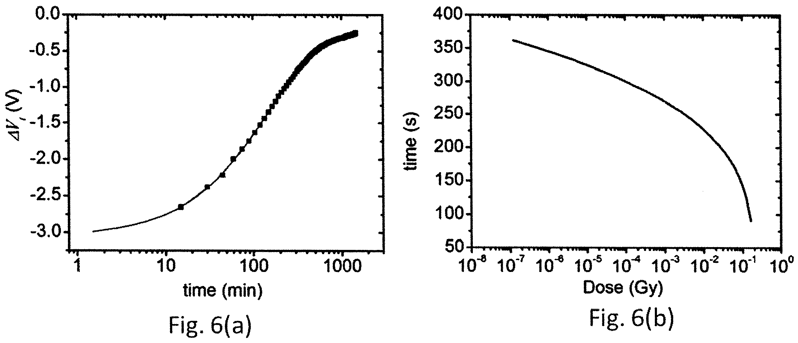

Figures 6a and 6b displays a recovery measurement, in which the threshold voltage was monitored for 22 hours after an exposure to a dose of 21 Gy. The curve follows a stretched exponential with a characteristic time-scale of a few hours.

From these data, it is possible to calculate the time in which readout of the device 100 has to be carried out, to keep the error due to recovery drift below 10%. Due to the stretched exponential behavior, this time interval depends on the detected dose with longer retention times being observed at lower doses. From these data, defining a maximum readout time, which is plotted in figure 6b as a function of the radiation dose, is possible.

The maximum readout time interval is defined here as the time after an X-ray exposure event in which the drift in threshold voltage remains below 10%.

In the range where the device 100 shows a linear response, the maximum readout time exceeds 300 sec. This long retention time makes even the sequential readout of a large detector array feasible.

The manufacturing of an ionization sensitive field effect device 100 comprises the following main steps.

The gate electrode 140 is deposited on the flexible substrates 160 using materials processing via physics routes such as sputtering or chemical routes, such as solution based processes, such as screen printing, sol gel, among others. Patterning of gate electrodes 140 is performed with photolithography and etching processes or lift-off.

The dielectric layer 150 can be deposited using different techniques such as RF-sputtering, from two separate targets containing SiO₂ and Ta₂O₅ or via solution-based processes, containing the elements above mentioned. Both processes can be run in parallel. For the sputtering case, a mechanical shutter was used, so as to create the multilayer structure of the dielectric layer 150, by alternating depositions of SiO₂ only and co-depositions of SiO₂ and Ta₂O₅. For solution route method, the thickness was determined by the number of deep steps (e.g. sol gel deep coating), or by the amount of material spread over the surface (e.g. screen printing). Patterning of dielectric layer 150 is performed with photolithography and etching processes or lift-off.

The subsequent step is to deposit a high mobility amorphous oxide semiconductor channel 110 on the dielectric layer 150, using materials processing via physics routes, such as sputtering or chemical routes, such as solution based processes (e.g. screen printing, sol gel, among others). Patterning of oxide semiconductor channel 110 is performed with photolithography and etching processes or lift-off.

Finally, said source electrode 120 and said drain electrode 130 are deposited using materials processing via physics routes such as sputtering or chemical routes, such as solution based processes, such as screen printing, sol gel, and the like, after a photolithography process. Said source electrode 120 and said drain electrode 130 are patterned using lift-off.

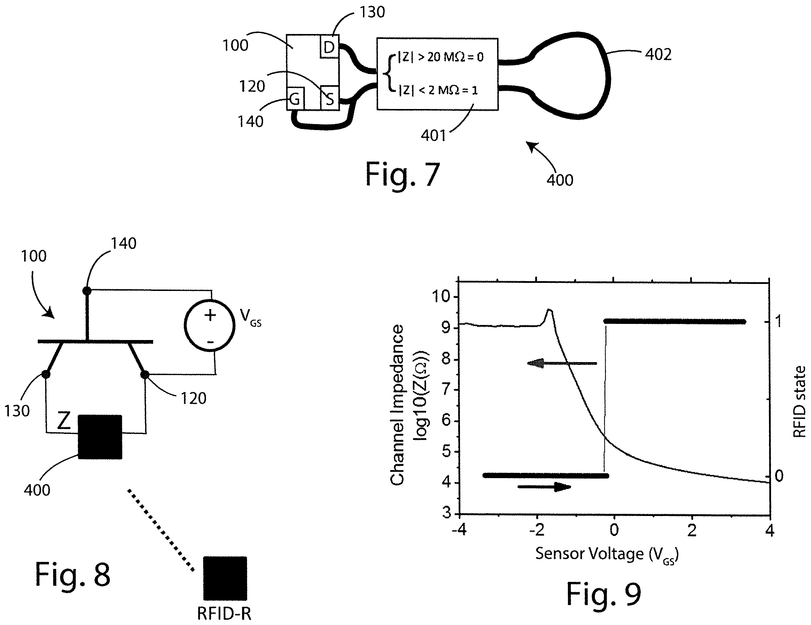

According to the invention, the field effect device 100 is connected to a RFID transmitter. In particular, referring to figure 7, general electrical connection of the field effect device 100 according to the invention is seen, with an RFID transmitter 400, properly integrated together with said device 100.

Said RFID transmitter 400 comprises a RFID chip 401, connected to the source electrode 120 and the drain electrode 130, namely it is parallel connected to the semiconductor channel layer 110, and an antenna 402 is in its turn connected to said RFID chip 400. In the figure, typical levels of impedance Z determining the logic states are also shown.

In addition, figure 8 shows the connection between the field effect device 100 with a RFID transmitter 400, whose RFID chip 401 is connected between the source 120 and the drain 130 of the field effect device 100, where the RFID transmitter 400 is remotely connected to a RFID receiver RFID-R, through the antenna 402.

Upon a sensing event, the potential V_{GS} between the gate terminal 140 and the source terminal 120 is subject to a variation. Then the semiconductor channel layer 110 impedance Z varies according to a characteristic curve like the one plotted in figure 9.

The RFID transmitter state is then switched from high-impedance (0 logic state) to low-impedance (1 logic state), as shown in said figure 9.

As it can be seen, upon the sensing event the semiconductor channel layer 110, the impedance Z decreases considerably, allowing the change of the logic state, if measured in voltage, between the source 120 and the drain 130 electrodes of the field effect device 100.

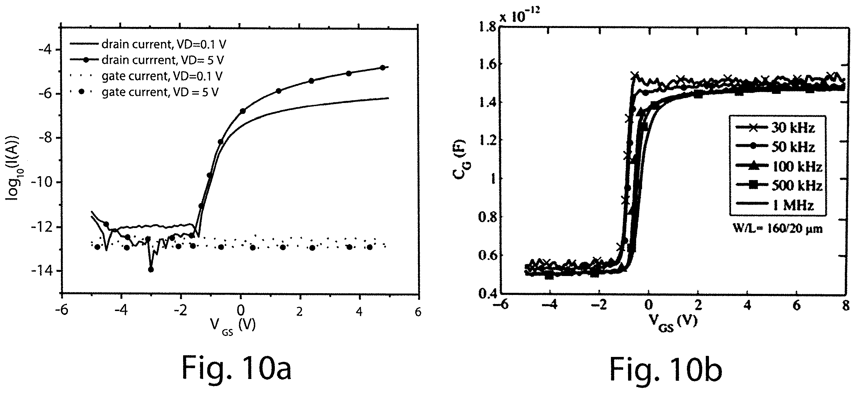

Figures 10a and 10b show the transfer characteristics of a field effect device 100 and its frequency response. In particular, in said figures 10a and 10b there are respectively plotted the drain currents and the gate currents as a function of gate-source voltage, at different drain voltages, and the gate capacity (in picoFarad) C_{G} as a function of the gate-source voltage V_{GS}, at different frequencies.

Upon a sensing event, the voltage at the gate electrode 140 remains constant, thus leaving unaltered the impedance Z probed by the RFID chip 401. In this way, the occurrence of the sensing event is stored in a passive memory state, as better explained below, where some applications of the field effect device 100 are examined, particularly directed toward the application of the RFID devices, for which, as it is well known, high sensitive devices are required to improve the detection sensitivity.

Indeed, in many applications it is necessary to guarantee that environmental conditions for example in a working place, in a storage room, in a technical engine (motor, computer) or in a parcel remain within a certain tolerance interval to avoid a possible health risk or damage.

For the applications described below the following parameters are relevant:
- sufficiently high on/off ratio that matches the impedance requirements of typical RFID chip 401;
- steep sub-threshold slope, which determines the width of the transition region, in which the sensor state is not well defined;
- low parasitic capacitance to realize a high impedance state also at high operation frequencies;
- a low leakage current (<10 nA/cm²), to realize stable charge storage; and
- a high cut-off frequency (>30 kHz) to realize a low-impedance state at RFID chip 401 frequencies.

From the polarization standpoints, it is apparent that the device 100 is operated close to threshold, therefore even small voltage variations normally between the gate electrode 140 and the source electrode 120 lead to large variations in semiconductor channel 110 impedance that are directly detected by the RFID sensor 400 terminals.

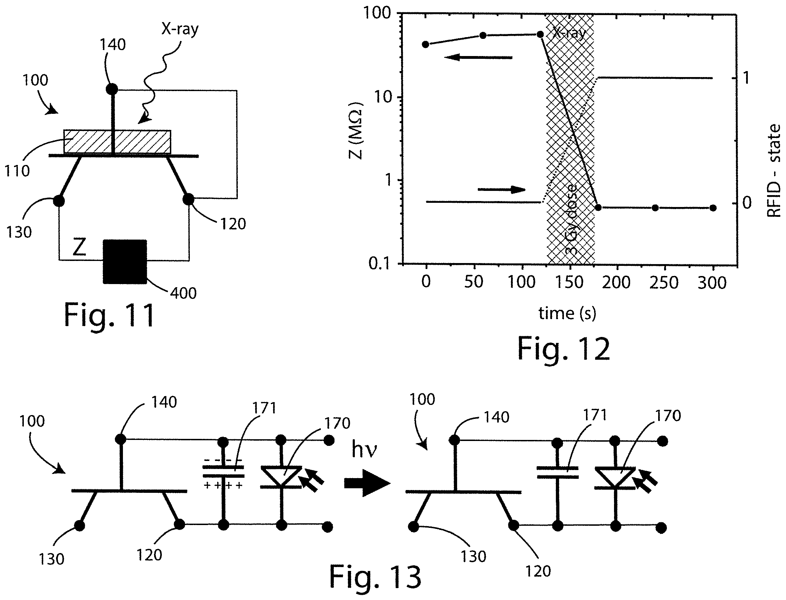

Figure 11 shows the field effect device 100, according to the first embodiment, where a RFID transmitter 400 is connected between the source electrode 120 and the drain electrode 130, then parallel with the semiconductor channel layer 110. The source electrode 120 is also connected with the gate electrode 140. An ionization radiation beam, X-rays in the figure, beams on the semiconductor channel layer 110, causing the logic state switch, as shown in figure 12, due to the impedance increase of the semiconductor channel layer 110.

This logic switch configuration is read by RFID transmitter 400, which transmits an RFID receiver RFID-R, by the related antenna 402.

Referring to figure 13-15, a first example of the field effect device 100 is shown, which does not form part of the present invention, where the sensing means comprises a photodiode 170 and a capacitor 171, both parallel connected to said gate electrode 140 and said source electrode 120.

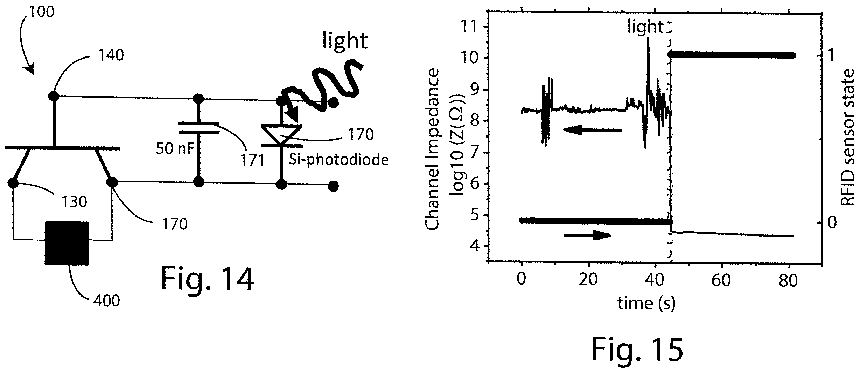

When a light beam, having a wavelength within the visible band or in the nearby of the same (e.g. UV or IR bands), reaches said photodiode 170, the latter conduces, so that the potential between the gate electrode 140 and the source electrode 120 varies. Figure 15 shows the variation of the impedance of the semiconductor channel layer 110 and the consequent RFID chip 401 logic state switch as a function of time.

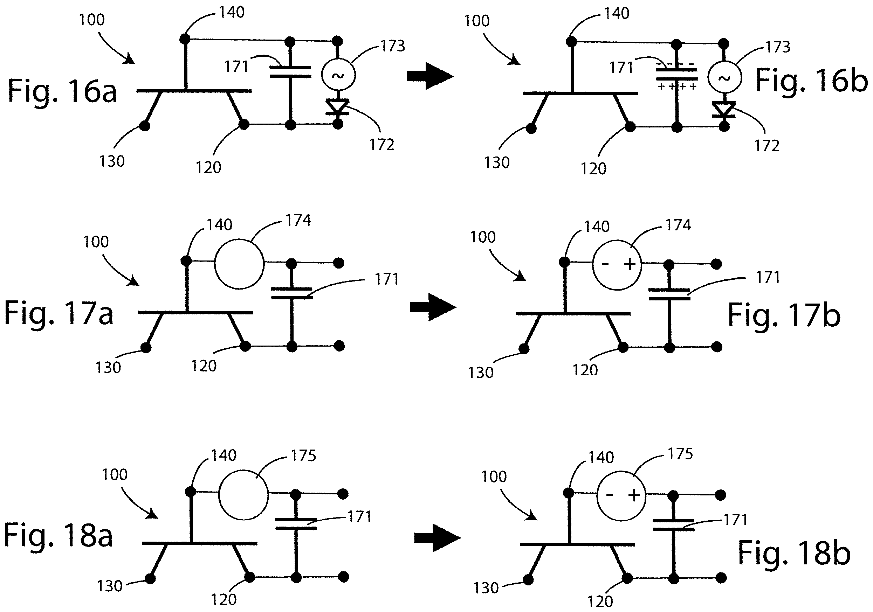

Figures 16a and 16b show a second example of the field effect device, which does not form part of the present invention, wherein the sensing means of said field effect device 100 comprises a capacity 171, connected between said gate electrode 140 and said source electrode 120, and a rectifier diode 172, series connected with a piezoelectric sensor 173, connected to said gate electrode 140 and to said source electrode 120.

In case of a mechanical stress is applied to the piezoelectric sensor 173, the gate - source potential changes, causing a variation of the impedance of the semiconductor channel layer 110, thus allowing the logic switching off the field effect device 100.

Referring now to figures 17a and 17b, a third example of the field effect device is shown, which does not form part of the present invention, in which sensing means comprises a capacitor 171 and a pyroelectric sensor 174, capable of sensing the environment temperature. The capacitor 171 and said pyroelectric sensor 174 are series connected.

Said sensing means are connected between the gate electrode 140 and the source electrode 120, as the other embodiments above described.

The operation of this example is the analogous of the others. Variation of the gate - source potential V_{GS} causes the variation of the impedance Z of the semiconductor channel layer 110.

Referring to figures 18a and 18b, a fourth example of the field effect device is shown, which does not form part of the present invention, wherein the sensor means now comprises a capacitor 171 and a chemical sensor 175. The connection of said chemical sensor 175 and said capacitor 171 is the same the third example described above.

Also the electrical operation is the same of the third example shown in figures 17a and 17b, with the apparent difference that in that case it is a chemical substance detection, as sensing event, that changes the electrical state of the sensor and then the gate - source voltage, so as to change the impedance between said source electrode 120 and said drain electrode 130.

As it can be seen, in all the embodiments described above, a RFID chip 401 can be connected between said source electrode 120 and said drain electrode 130, so as to detect the variation of the potential between said electrodes, in transmitting the states change, namely the detection of ionization radiation, light, mechanical stress, variation of temperature and detection of chemical substances to a RFID receiver RFID-R.

It is seen that even the above mentioned passive components, as the capacitor 171, as well as the different sensors, can be integrated in a single device.

In addition, the several above mentioned sensing means can be combined each other.

An advantage of the field effect device according to the invention is that of enabling to create low-cost RFID sensors capable of monitoring if ionizing radiation goes beyond a defined threshold. Once conditions are beyond threshold, the RFID sensor state is changed and the event can be traced at a later time using a wireless RFID readout systems.

A further advantage of the device according to the invention is that of introducing innovative nanostructured materials allowing to combine unique electronic sensor performance, with the possibility to deposit sensors in microstructured arrays on large-areas and on flexible plastic substrates.

The present invention has been described for illustrative but not limitative purposes, according to its preferred embodiments, but it is to be understood that modifications and/or changes can be introduced by those skilled in the art without departing from the relevant scope as defined in the enclosed claims.

## Claims

1. Detecting sensor comprising:
a substrate (160);
a plurality of ionization sensitive field effect devices (100), arranged on said substrate (160), wherein each of said ionization sensitive field effect devices (100) comprises
a semiconductor channel (110), wherein said semiconductor channel (110) is a layer and is made of an amorphous oxide,
a source electrode (120) connected to said semiconductor channel (110),
a drain electrode (130) connected to said semiconductor channel (110), such that said semiconductor channel (110) is interposed between said source electrode (120) and said drain electrode (130),
a gate electrode (140) having a gate capacity (*C_{G}*), wherein the gate capacity (*C_{G}*) is a function of the gate-source voltage (*V_{GS}*) at different frequencies, and
a dielectric layer (150),
interposed between said gate electrode (140) and said semiconductor channel (110),
wherein said dielectric layer (150) is arranged in order to be exposable to an ionizing radiation, such as X-rays and the like,
wherein said gate electrode (140) comprises at least one main layer, made of at least one material having at least one cation element with atomic number selected so as to increase the absorption of said incident ionizing radiation to be sensed, and
wherein said at least one material of said dielectric layer (150) has a high atomic number Z, said atomic number Z being higher than 36 (Z>36); and
at least one RFID transmitter (400) having a pair of electrodes connected to the source electrode (120) and the gate electrode (140) of a related field effect device (100), configured for being connectable to a RFID receiver (RFID-R);
wherein said RFID transmitter (400) switches its state from a first logic state of high-impedance to a second logic state of low-impedance upon an ionization event and transmits the state change to said RFID receiver (RFID-R).

2. Sensor according to the preceding claim, **characterized in that** said amorphous oxide is high mobility amorphous oxide type and it is selected from the group comprising: Indium Gallium Zinc Oxide (IGZO) and/or Indium Hafnium Zinc Oxide (IHZO) and/or Zinc Tin Oxide (ZTO) and/or Gallium Zinc Tin Oxide (GZTO).

3. Sensor according to any one of the preceding claims, **characterized in that** said at least one main layer of said dielectric layer (150) is made of Yttrium Oxide (Y2O3) and/or Zirconium Oxide (ZrO₂) and/or Hafnium Oxide (HfO2) and/or Tantalum Pentoxide (Ta2O5) and/or Bismuth Oxide (Bi2O₃).

4. Sensor according to any one of the preceding claims, **characterized in that** said dielectric layer (150) of each one of said devices (100) is in electrical contact with said source electrode (120) and said drain electrode (130).

5. Sensor according to any one of the preceding claims, **characterized in that** said dielectric layer (150) of each one of said devices (100) has a thickness greater than or equal 150 nm.

6. Sensor according to any one of the preceding claims, **characterized in that** said dielectric layer (150) of each one of said devices (100) is a multilayer, comprising one or more insulating layers with an atomic number lower than atomic number of said main layer.

7. Sensor according to the preceding claim, **characterized in that** said one or more insulating layers of said dielectric layer (150) of each one of said devices (100) are made of silicon-dioxide (SiO₂) and/or aluminum-oxide (Al₂O₃).

8. Sensor according to any one of claims 6 or 7, **characterized in that** said dielectric layer (150) of each one of said devices (100) comprises
the combination of said insulating layer, with lower atomic number atoms, and said main layer repeated from two to ten times, and
a top layer of the said insulating layer with lower atomic number atoms.

9. Sensor according to any one of the preceding claims, **characterized in that** each one of said devices (100) comprises at least one substrate (160), on which said gate electrode (140) and said dielectric layer (150) are deposited.

10. Device (100) according any one of the preceding claims, **characterized in that** said gate (140), source (120) and drain (130) electrodes of each one of said devices (100) are made of conductive materials, such as molybdenum (Mo), copper (Cu), aluminum (Al), gold (Au) and/or silver (Ag), and/or conducting oxides, such as Gallium-doped Zinc Oxide (GZO) or Indium Zinc Oxide (IZO) and/or conducting polymers such as Pedot: Pss.

11. Sensor according to anyone of the preceding claims, **characterized in that** said substrate is flexible and it is preferably made of Polyethylene Naphthalate.

12. Sensor according any one of the preceding claims, **characterized in that** said field effect devices (100) are arranged as an array or as a matrix.

13. Sensor according to any one of the preceding claims, **characterized in that** said RFID transmitter (400) comprises an RFID chip (401) and an antenna (402).

14. Sensor according any one of the preceding claims, **characterized in that** it comprises a plurality of RFID transmitter (400), each one being operatively connected to a related field effect devices (100).

## Patentansprüche

1. Erkennender Sensor mit:
ein Substrat (160);
eine Vielzahl von ionisationssensitiven Feldeffektvorrichtungen (100), die auf dem Substrat (160) angeordnet sind, wobei jedes der ionisationssensitiven Feldeffektvorrichtungen (100) Folgendes umfasst
einen Halbleiterkanal (110), wobei der Halbleiterkanal (110) eine Schicht ist und aus einem amorphen Oxid hergestellt ist,
eine Source-Elektrode (120), die mit dem Halbleiterkanal (110) verbunden ist,
eine Drain-Elektrode (130), die mit dem Halbleiterkanal (110) verbunden ist, so dass der Halbleiterkanal (110) zwischen der Source-Elektrode (120) und der Drain-Elektrode (130) angeordnet ist,
eine Gate-Elektrode (140) mit einer Gate-Kapazität (*C_{G}*), wobei die Gate-Kapazität (*C_{G}*) eine Funktion der Gate-Source-Spannung (*V_{GS}*) bei verschiedenen Frequenzen ist, und
eine dielektrische Schicht (150),
die zwischen der Gate-Elektrode (140) und dem Halbleiterkanal (110) angeordnet ist,
wobei die dielektrische Schicht (150) so angeordnet ist, dass sie einer ionisierenden Strahlung, wie Röntgenstrahlen und dergleichen, ausgesetzt werden kann, wobei die Gate-Elektrode (140) mindestens eine Hauptschicht umfasst, die aus mindestens einem Material besteht, das mindestens ein Kationselement mit einer Atomzahl aufweist, die so gewählt ist, dass sie die Absorption der einfallenden, zu erfassenden ionisierenden Strahlung erhöht, und
wobei das mindestens ein Material der dielektrischen Schicht (150) eine hohe Ordnungszahl Z aufweist, wobei die Ordnungszahl Z höher als 36 (Z>36) ist; und
mindestens einen RFID-Sender (400) mit einem Paar von Elektroden, die mit der Source-Elektrode (120) und der Gate-Elektrode (140) eines zugehörigen Feldeffekt-Bauelements (100) verbunden sind, das so konfiguriert ist, dass es mit einem RFID-Empfänger (RFID-R) verbunden werden kann;
wobei der RFID-Sender (400) seinen Zustand bei einem Ionisierungsereignis von einem ersten logischen Zustand hoher Impedanz in einen zweiten logischen Zustand niedriger Impedanz umschaltet und die Zustandsänderung an den RFID-Empfänger (RFID-R) überträgt.

2. Sensor nach dem vorhergehenden Anspruch, **dadurch gekennzeichnet, dass** das amorphe Oxid vom Typ des amorphen Oxids mit hoher Mobilität ist und aus der Gruppe ausgewählt ist, die umfasst: Indium-Gallium-Zink-Oxid (IGZO) und/oder Indium-Hafnium-Zink-Oxid (IHZO) und/oder Zink-Zinn-Oxid (ZTO) und/oder Gallium-Zink-Zinn-Oxid (GZTO).

3. Sensor nach einem der vorhergehenden Ansprüche, **dadurch gekennzeichnet, dass** die mindestens eine Hauptschicht der dielektrischen Schicht (150) aus Yttriumoxid (Y2O3) und/oder Zirkoniumoxid (ZrO₂) und/oder Hafniumoxid (HfO2) und/oder Tantalpentoxid (Ta2O5) und/oder Bismutoxid (Bi2O₃) besteht.

4. Sensor nach einem der vorhergehenden Ansprüche, **dadurch gekennzeichnet, dass** die dielektrische Schicht (150) jeder der Vorrichtungen (100) in elektrischem Kontakt mit der Source-Elektrode (120) und der Drain-Elektrode (130) steht.

5. Sensor nach einem der vorhergehenden Ansprüche, **dadurch gekennzeichnet, dass** die dielektrische Schicht (150) jeder der Vorrichtungen (100) eine Dicke größer oder gleich 150 nm aufweist.

6. Sensor nach einem der vorhergehenden Ansprüche, **dadurch gekennzeichnet, dass** die dielektrische Schicht (150) jeder der Vorrichtungen (100) eine Mehrschicht ist, die eine oder mehrere isolierende Schichten mit einer niedrigeren Ordnungszahl als die Ordnungszahl der Hauptschicht umfasst.

7. Sensor nach dem vorhergehenden Anspruch, **dadurch gekennzeichnet, dass** die eine oder mehreren Isolierschichten der dielektrischen Schicht (150) jeder der Vorrichtungen (100) aus Siliziumdioxid (SiO₂) und/oder Aluminiumoxid (Al₂O₃) hergestellt sind.

8. Sensor nach einem der Ansprüche 6 oder 7, **dadurch gekennzeichnet, dass** die dielektrische Schicht (150) jeder der Vorrichtungen (100) Folgendes umfasst
die Kombination aus der Isolierschicht mit Atomen niedrigerer Ordnungszahl und der Hauptschicht zwei- bis zehnmal wiederholt wird, und
eine obere Schicht der genannten Isolierschicht mit Atomen niedrigerer Ordnungszahl.

9. Sensor nach einem der vorhergehenden Ansprüche, **dadurch gekennzeichnet, dass** jede der Vorrichtungen (100) mindestens ein Substrat (160) umfasst, auf dem die Gate-Elektrode (140) und die dielektrische Schicht (150) aufgebracht sind.

10. Vorrichtung (100) nach einem der vorhergehenden Ansprüche, **dadurch gekennzeichnet, dass** die Gate- (140), Source- (120) und Drain- (130) Elektroden jeder der Vorrichtungen (100) aus leitendem Material, wie Molybdän (Mo), Kupfer (Cu), Aluminium (Al), Gold (Au) und/oder Silber (Ag), und/oder leitenden Oxiden, wie Galliumdotiertem Zinkoxid (GZO) oder Indium-Zinkoxid (IZO) und/oder leitenden Polymeren, wie Pedot, hergestellt sind: Pss.

11. Sensor nach einem der vorhergehenden Ansprüche, **dadurch gekennzeichnet, dass** das Substrat flexibel ist und vorzugsweise aus Polyethylennaphthalat besteht.

12. Sensor nach einem der vorhergehenden Ansprüche, **dadurch gekennzeichnet, dass** die Feldeffektvorrichtungen (100) als Array oder als Matrix angeordnet sind.

13. Sensor nach einem der vorhergehenden Ansprüche, **dadurch gekennzeichnet, dass** der RFID-Sender (400) einen RFID-Chip (401) und eine Antenne (402) umfasst.

14. Sensor nach einem der vorhergehenden Ansprüche, **dadurch gekennzeichnet, dass** er eine Vielzahl von RFID-Sendern (400) umfasst, von denen jeder operativ mit einer zugehöriger Feldeffektvorrichtung (100) verbunden ist.

## Revendications

1. Capteur de détection comprenant:
un substrat (160);
une pluralité de dispositifs sensibles à effet de champ à l'ionisation (100), disposés sur ledit substrat (160), dans lesquels chacun desdits dispositifs sensibles à effet de champ à l'ionisation (100) comprend
un canal semi-conducteur (110), dans lequel ledit canal semi-conducteur (110) est une couche et est constitué d'un oxyde amorphe,
une électrode source (120) connectée audit canal semi-conducteur (110),
une électrode de drain (130) connectée audit canal semi-conducteur (110), de telle sorte que ledit canal semi-conducteur (110) est interposé entre ladite électrode source (120) et ladite électrode de drain (130),
une électrode de grille (140) ayant une capacité de grille (*C_{G}*)*,* dans laquelle la capacité de grille (*C_{G}*) est une fonction de la tension grille-source (*V_{GS}*) à différentes fréquences, et
une couche diélectrique (150),
interposée entre ladite électrode de grille (140) et ledit canal semi-conducteur (110),
où ladite couche diélectrique (150) est disposée de manière à être exposée à un rayonnement ionisant, tel que les rayons X et autres,
où ladite électrode de grille (140) comprend au moins une couche principale, constituée d'au moins un matériau comportant au moins un élément cation dont le numéro atomique est choisi de manière à augmenter l'absorption dudit rayonnement ionisant incident à détecter, et
où ledit au moins un matériau de ladite couche diélectrique (150) a un numéro atomique Z élevé, ledit numéro atomique Z étant supérieur à 36 (Z>36); et
au moins un émetteur RFID (400) comportant une paire d'électrodes connectées à l'électrode source (120) et à l'électrode de grille (140) d'un dispositif à effet de champ connexe (100), configuré pour être connecté à un récepteur RFID (RFID-R);
où ledit émetteur RFID (400) passe d'un premier état logique de haute impédance à un second état logique de basse impédance lors d'un événement d'ionisation et transmet le changement d'état au récepteur RFID (RFID-R) .

2. Capteur selon la revendication précédente, **caractérisé en ce que** ledit oxyde amorphe est du type oxyde amorphe à haute mobilité et est choisi dans le groupe comprenant: Oxyde de zinc indium gallium (IGZO) et/ou oxyde de zinc indium hafnium (IHZO) et/ou oxyde de zinc étain (ZTO) et/ou oxyde de zinc étain gallium (GZTO) .

3. Capteur selon l'une quelconque des revendications précédentes, **caractérisé en ce que** ladite au moins une couche principale de ladite couche diélectrique (150) est constituée d'oxyde d'yttrium (Y2O3) et/ou d'oxyde de zirconium (ZrO₂) et/ou d'oxyde d'hafnium (HfO2) et/ou de pentoxyde de tantale (Ta2O5) et/ou d'oxyde de bismuth (Bi2O₃).

4. Capteur selon l'une quelconque des revendications précédentes, **caractérisé en ce que** ladite couche diélectrique (150) de chacun desdits dispositifs (100) est en contact électrique avec ladite électrode source (120) et ladite électrode de drain (130).

5. Capteur selon l'une quelconque des revendications précédentes, **caractérisé en ce que** ladite couche diélectrique (150) de chacun desdits dispositifs (100) a une épaisseur supérieure ou égale à 150 nm.

6. Capteur selon l'une quelconque des revendications précédentes, **caractérisé en ce que** ladite couche diélectrique (150) de chacun desdits dispositifs (100) est une multicouche, comprenant une ou plusieurs couches isolantes de numéro atomique inférieur au numéro atomique de ladite couche principale.

7. Capteur selon la revendication précédente, **caractérisé en ce que** lesdites une ou plusieurs couches isolantes de ladite couche diélectrique (150) de chacun desdits dispositifs (100) sont constituées de dioxyde de silicium (SiO₂) et/ou d'oxyde d'aluminium (Al₂O₃).

8. Capteur selon l'une quelconque des revendications 6 ou 7, **caractérisé en ce que** ladite couche diélectrique (150) de chacun desdits dispositifs (100) comprend
la combinaison de ladite couche isolante, avec des atomes de numéro atomique inférieur, et de ladite couche principale répétée de deux à dix fois, et
une couche supérieure de ladite couche isolante avec des atomes de numéro atomique inférieur.

9. Capteur selon l'une quelconque des revendications précédentes, **caractérisé en ce que** chacun desdits dispositifs (100) comprend au moins un substrat (160), sur lequel sont déposées ladite électrode de grille (140) et ladite couche diélectrique (150).

10. Dispositif (100) selon l'une quelconque des revendications précédentes, **caractérisé en ce que** lesdites électrodes de grille (140), source (120) et de drain (130) de chacun desdits dispositifs (100) sont constituées d'un matériau conducteur, tel que le molybdène (Mo), le cuivre (Cu), l'aluminium (Al), l'or (Au) et/ou l'argent (Ag), et/ou d'oxydes conducteurs, tels que l'oxyde de zinc dopé au gallium (GZO) ou l'oxyde de zinc dopé à l'indium (IZO) et/ou de polymères conducteurs tels que Pedot: Pss.

11. Capteur selon l'une quelconque des revendications précédentes,
**caractérisé par le fait que** ledit substrat est flexible et qu'il est de préférence en polyéthylène naphtalate.

12. Capteur selon l'une quelconque des revendications précédentes, **caractérisé en ce que** lesdits dispositifs à effet de champ (100) sont disposés en réseau ou en matrice.

13. Capteur selon l'une quelconque des revendications précédentes, **caractérisé en ce que** ledit émetteur RFID (400) comprend une puce RFID (401) et une antenne (402) .

14. Capteur selon l'une quelconque des revendications précédentes, **caractérisé en ce qu'**il comprend une pluralité d'émetteurs RFID (400), chacun étant connecté de manière opérationnelle à un dispositif à effet de champ connexe (100).
